# EUROPEAN PATENT SPECIFICATION

(11) **EP 3 147 329 B1**
(45) Date of publication and mention of the grant of the patent: **23.02.2022**
(21) Application number: 16189328.4
(22) Date of filing: 16.09.2016
(51) Int. Cl.: C08L 83/04, H01L 23/29

(54) **HEAT-CURABLE SILICONE RESIN COMPOSITION, OPTICAL SEMICONDUCTOR DEVICE AND SEMICONDUCTIOR PACKAGE USING MOLDED PRODUCT OF SAME**
WÄRMEHÄRTBARE SILIKONHARZZUSAMMENSETZUNG, OPTISCHE VORRICHTUNG UND HALBLEITERVERPACKUNG MIT GEFORMTEM PRODUKT DARAUS
COMPOSITION DE RÉSINE DE SILICONE THERMODURCISSABLE, DISPOSITIF À SEMI-CONDUCTEURS OPTIQUES ET BOÎTIER À SEMI-CONDUCTEURS UTILISANT UN PRODUIT MOULÉ DE CELLE-CI

(30) Priority: 28.09.2015 JP 2015189234
(43) Date of publication of application: 29.03.2017
(73) Proprietor: Shin-Etsu Chemical Co., Ltd., Chiyoda-ku, Tokyo 100-0004 (JP)
(72) Inventor: Tsutsumi, Yoshihiro, Gunma, 379-0224 (JP); Shimoda, Taro, Gunma, 379-0224 (JP); Kaneta, Masahiro, Gunma, 379-0224 (JP); Tomita, Tadashi, Gunma, 379-0224 (JP)
(74) Representative: Angerhausen, Christoph

(56) References cited:
- EP-A1- 2 174 984
- EP-B1- 2 174 984

## Description

### [Technical field]

The present invention relates to a heat-curable silicone resin composition; and an optical semiconductor device and a semiconductor package each employing a cured product of such composition.

### [Background art]

In recent years, as electronic parts such as semiconductor packages have become smaller and thinner, encapsulation resins used to encapsulate these electronic parts have become significantly thinner as well. Meanwhile, with regard to encapsulation of electronic parts such as semiconductor packages, transfer molding has been considered as a mainstream method where a solid epoxy resin composition is used. However, when resin-encapsulating such a kind of thin semiconductor package through transfer molding, wire deformation may occur because narrow spaces in the package need to be filled with a resin in such case. For this reason, when employing transfer molding with a solid epoxy resin composition, a large encapsulation area will make it easier for filling failures to occur.

Therefore, in recent years, with regard to encapsulation of thin semiconductor packages and wafer-level packages where large areas are encapsulated, there has been employed a compression molding method where a liquid epoxy resin composition is used. As a result of using a liquid epoxy resin composition in the compression molding method, the epoxy resin will exhibit an extremely low viscosity at the time of performing resin encapsulation molding as compared to the case where a solid epoxy resin composition is used. Here, wire deformation is less likely to occur due to such reason, and it was thus expected that a large area could be encapsulated in a collective manner.

However, when collectively encapsulating a large area of a package, warpage of such package that occurs after performing resin encapsulation molding has been a major problem. As a solution to such problem, there have been known methods for reducing a thermal stress after resin encapsulation molding, by adding a large amount of an inorganic filler(s) to the liquid epoxy resin composition (e.g. Patent documents 1 to 3). The thermal stress exhibited after resin encapsulation molding will certainly decrease by adding a large amount of an inorganic filler(s) to the liquid epoxy resin composition. However, the viscosity of the liquid epoxy resin composition will increase under such condition, which will then make the liquid epoxy resin composition not much of a liquid composition. That is, a liquid epoxy resin composition containing a large amount of an inorganic filler(s) makes it easy for wire sweep as a type of wire deformation and filling failure to occur, and thus has a difficulty when used to perform encapsulation at the time of manufacturing a semiconductor package.

Further, as a result of promoting innovations in packaging technologies for semiconductor devices, semiconductor elements nowadays generate larger amounts of heat due to the highly improved performances and high integration of semiconductor devices. Therefore, a junction temperature has reached as high as 150 to 175°C. Although a device as a whole is often configured in a way such that heat can be easily dissipated therefrom, it is also required that an encapsulation resin itself possess a heat resistance property (Patent document 4).

Meanwhile, optical semiconductor elements such as LEDs (Light Emitting Diodes) have been widely used as various indicators or light sources such as those for use in street displays, automobile lamps and residential lightings. Optical semiconductor elements of recent years have been progressively employing high-energy lights due to an increased output for improving luminance, and due to a shortened wavelength for improving color rendering properties. In addition, as a light reflective material, there have been often used a thermal plastic resin such as polyphthalamide resin (PPA); and a material such as liquid crystal polymer. However, a significant discoloring has been observed in light reflective parts using these materials, as a result of being exposed to heat and light.

Thus, there has been proposed a light-reflective heat-curable resin composition exhibiting an optical reflectance of not lower than 70% within a range of 350 to 800 nm (Patent document 5). However, since this composition is an epoxy resin composition, problems such as yellowing of a cured product thereof may occur when used in a high-temperature environment for a long period of time, and when an LED using the same is that of a high-luminance type such as a UVLED, a white LED and a blue LED.

Further, as for optical semiconductor materials, wafer-level packaging is beginning to be employed for the purpose of increasing the number of light emitting elements obtainable and simplifying the packaging process. However, a newly adopted substrate for mounting optical semiconductor elements differs from its conventional counterpart having a reflective surface in that the newly adopted substrate is configured in a way such that a resin composition adheres to a light-emitting element(s), which may then lead to light- and heat-induced deteriorations that are more intense than ever. Thus, the existing epoxy resin compositions are far from being able to meet reliability requirements.

As a countermeasure, there has been a report about a white silicone resin composition as a material superior in heat resistance and light resistance (Patent document 6). However, this composition is a type of material used to perform transfer molding; and has a difficulty not only in performing molding, but also in reducing warpage, when used as an encapsulation material for wafer-level packaging.

Also Patent document 7 discloses a heat-curable composition comprising a resinous polysiloxane, an organopolysiloxane containing phenyl groups and a linear residue, an inorganic filler, a condensation curing catalyst, a silane coupling agent, and a white pigment.

### [Prior art document]

### [Patent document]

Patent document 1 JP-A-H8-41293
Patent document 2 JP-A-2002-121260
Patent document 3 JP-A-2007-23272
Patent document 4 JP-A-2004-204082
Patent document 5 JP-A-2006-140207
Patent document 6 JP-A-2013-107984
Patent document 7 EP 2 174 984 Al

### [Summary of the invention]

### [Problem to be solved by the invention]

It is an object of the present invention to provide a heat-curable silicone resin composition having a superior long-term reliability and a low-warpage property; and an optical semiconductor device and a semiconductor package each having a cured product of such composition that is obtained in a compression molding step.

### [Means to solve the problem]

The inventors of the present invention diligently conducted a series of studies to achieve the above objectives, and completed the invention as follows. That is, the inventors found that the following heat-curable silicone resin composition could form a cured product having a superior long-term reliability and a low-warpage property, and that this composition was useful in an optical semiconductor device and/or a semiconductor package each requiring a step of forming an optical semiconductor element-mounted area and/or a semiconductor element-mounted area through compression molding.

That is, the present invention provides the following heat-curable silicone resin composition.

A heat-curable silicone resin composition comprising:
a molten mixture of
(A) a resinous organopolysiloxane that has a weight-average molecular weight of 500 to 20,000 in terms of polystyrene, and is represented by the following average composition formula (1)

   (CH₃)ₐSi(OR¹)_{b}(OH)_{c}O_{(4-a-b-c)/2} (1)

   wherein each R¹ represents an identical or different organic group having 1 to 4 carbon atoms, and a, b and c are numbers satisfying 0.8 ≤ a ≤ 1.5, 0 ≤ b ≤ 0.3, 0.001 ≤ c ≤ 0.5 and 0. 801 ≤ a+b+c < 2, and
(B) an organopolysiloxane that contains in one molecule at least one cyclohexyl group or phenyl group, and has a linear diorganopolysiloxane residue represented by the following general formula (2) 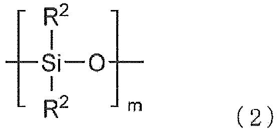
wherein each R² independently represents a monovalent hydrocarbon group selected from a hydroxyl group, an alkyl group having 1 to 3 carbon atoms, a cyclohexyl group, a phenyl group, a vinyl group and an allyl group, and m represents an integer of 5 to 50;
(C) an inorganic filler;
(D) a curing catalyst; and
(E) a silane coupling agent, wherein the components (C), (D) and (E) are in the claimed amounts and wherein the components (A) and (B) are to be cured by a condensation reaction, and a difference between a storage elastic modulus of a cured product of the composition at 25°C and a storage elastic modulus of a cured product of the composition at 150°C is not larger than 4,000 MPa.

### [Effect of the invention]

Since the heat-curable silicone resin composition of the present invention can form a cured product having a superior long-term reliability and a low-warpage property, it is useful in an optical semiconductor device and a semiconductor package, and is especially useful in an optical semiconductor device and a semiconductor package that are manufactured through compression molding.

### [Mode for carrying out the invention]

The present invention is described in greater detail hereunder.

### (A) Resinous organopolysiloxane

An organopolysiloxane as a component (A) is capable of forming a cross-linked structure under the presence of a condensation catalyst as a component (D) described later, and is represented by the following average composition formula (1)

(CH₃)ₐSi(OR¹)_{b}(OH)_{c}O_{(4-a-b-c)/2} (1)

(In the above formula (1), each R¹ represents an identical or different organic group having 1 to 4 carbon atoms; a, b and c are numbers satisfying 0.8 ≤ a ≤ 1.5, 0 ≤ b ≤ 0.3, 0.001 ≤ c ≤ 0.5 and 0.801 ≤ a+b+c < 2.)

This resinous organopolysiloxane is a type of resinous organopolysiloxane (i.e. branched or having a three-dimensional network structure) exhibiting a weight-average molecular weight of 500 to 20,000 in terms of polystyrene, when measured through a gel permeation chromatography (GPC) where tetrahydrofuran or the like is used as a developing solvent. Further, it is more preferred that such resinous organopolysiloxane be that being solid at 25°C, and having a melting point of 50 to 80°C.

A composition containing the organopolysiloxane represented by the above average composition formula (1) is not preferable, when "a" in the formula (1) which represents the contained amount of methyl groups is smaller than 0.8. This is because a cured product of such composition will become excessively hard, and exhibit a poor crack resistance accordingly. It is also not preferable when a is greater than 1.5. Because it will be difficult for the resinous organopolysiloxane obtained to solidify in such case. In terms of the contained amount of the methyl groups in the component (A), it is preferred that a be within a range of 0.8 ≤ a ≤ 1.2, more preferably 0.9 ≤ a ≤ 1.1.

In the above average composition formula (1), when "b" which represents the contained amount of alkoxy groups is greater 0.3, the resinous organopolysiloxane obtained tends to exhibit a small molecular weight, and a cured product thereof will often exhibit an impaired crack resistance. In terms of the contained amount of the alkoxy groups in the component (A), it is preferred that b be within a range of 0.01 ≤ b ≤ 0.2, more preferably 0.01 ≤ b ≤ 0.1.

In the above average composition formula (1), it is not preferable when "c" which represents the contained amount of hydroxyl groups bonded to Si atoms is greater than 0.5. This because the resinous organopolysiloxane obtained in such case will easily lead to a cured product with a high hardness but a poor crack resistance, due to a condensation reaction during heat-curing. Further, it is also not preferable when c is smaller than 0.001. Because the resinous organopolysiloxane obtained in such case tends to exhibit a high melting point, and a workability may thus be impaired. It terms of the contained amount of the hydroxyl groups bonded to the Si atoms in the component (A), it is preferred that c be within a range of 0.01 ≤ c ≤ 0.3, more preferably 0.05 ≤ c ≤ 0.2. In order to control the value of c to 0.001 ≤ c ≤ 0.5, it is preferred that a complete condensation rate of the alkoxy groups in a raw material be 86 to 96%. It is not preferable when such complete condensation rate is either lower than 86% or higher than 96%. Because a complete condensation rate of lower than 86% tends to lead to a low melting point as the value of c exceeds 0.5; whereas a complete condensation rate of higher than 96% tends to lead to an excessively high melting point as the value of c falls below 0.001. Here, the complete condensation rate refers to a ratio of the molar number of all the alkoxy groups in one molecule that were subjected to condensation reaction to the total molar number of a raw material.

In this way, it is preferred that in the above average composition formula (1), a + b + c be within a range of 0.9 ≤ a + b + c ≤ 1.8, more preferably 1.0 ≤ a + b + c ≤ 1.5.

In the above average composition formula (1), each R¹ represents an organic group having 1 to 4 carbon atoms. Examples of such organic group include an alkyl group such as a methyl group, an ethyl group and an isopropyl group, among which a methyl group and an isopropyl group are preferred in terms of ease of access to raw materials.

The resinous organopolysiloxane as the component (A) has a weight-average molecular weight of 500 to 20,000, preferably 1,000 to 10,000, more preferably 2,000 to 8,000, in terms of polystyrene when measured by GPC. When such molecular weight is smaller than 500, it may be difficult for the resinous organopolysiloxane to solidify. Further, when such molecular weight is larger than 20,000, the composition obtained may exhibit an excessively high viscosity such that the fluidity and eventually the moldability of the composition may be impaired.

In the present invention, the weight-average molecular weight refers to a value in terms of polystyrene, when measured through GPC under the following measurement conditions.
Measurement condition
Developing solvent: Tetrahydrofuran
Flow rate: 0.35 mL/min
Detector: RI
Column: TSK-GEL type H (by Tosoh Corporation)
Column temperature: 40°C
Injected amount of sample: 5 µL

The component (A) as represented by the above average composition formula (1) can be expressed by a combination of a Q unit (SiO_{4/2}), a T unit (CH₃SiO_{3/2}), a D unit ((CH₃)₂ SiO_{2/2}) and an M unit ((CH₃)₃SiO_{1/2}). When the component (A) is expressed in such manner, it is preferred that a ratio of the number of the T unit(s) contained to the total number of all the siloxane units (T unit ratio) be not smaller than 70% (70 to smaller than 100%), more preferably not smaller than 75% (75 to smaller than 100%), and particularly preferably not smaller than 80% (80 to smaller than 100%). A T unit ratio smaller than 70% may lead to an overall imbalance between, for example, the hardness, adhesiveness and appearance of the cured product obtained. Here, the remnant may be made of the M, D and Q units, and a molar ratio of a sum total of these units to all the siloxane units is not larger than 30% (0 to 30%), particularly not larger than 30% but larger than 0%. Therefore, it is preferred that the T unit(s) be contained at a ratio of about 100%.

The component (A) represented by the above average composition formula (1) can be obtained as a hydrolysis condensate of an organosilane represented by the following general formula (1a).

(CH₃)ₙSiX₄₋ₙ (1a)

(In the above formula, X represents a halogen atom such as a chlorine atom; or an alkoxy group having 1 to 4 carbon atoms. n is any of 0, 1 and 2.) In this case, it is preferred that X be a chlorine atom or a methoxy group in terms of obtaining a solid organopolysiloxane.

Examples of the silane compound represented by the above formula (1a) include an organotrichlorosilane such as methyltrichlorosilane; an organotrialkoxysilane such as methyltrimethoxysilane and methyltriethoxysilane; a diorganodialkoxysilane such as dimethyldimethoxysilane and dimethyldiethoxysilane; a tetrachlorosilane; and a tetraalkoxysilane such as tetramethoxysilane and tetraethoxysilane.

Although the above silane compound having a hydrolyzable group(s) may be hydrolyzed and condensed through a normal method, it is preferred that the silane compound be hydrolyzed and condensed under the presence of a catalyst. As such catalyst, there may be used any of an acid catalyst and an alkali catalyst. Preferable examples of such acid catalyst include an organic acid catalyst such as an acetic acid; and an inorganic acid catalyst such as a hydrochloric acid and a sulfuric acid. Preferable examples of the alkali catalyst include an alkali metal hydroxide such as sodium hydroxide and potassium hydroxide; and an organic alkali catalyst such as tetramethylammonium hydroxide. For example, when using a silane containing a chloro group as a hydrolyzable group, there can be obtained a target hydrolysis condensate having an appropriate molecular weight by employing a catalyst such as a hydrochloric gas generated by water addition and a hydrochloric acid.

The amount of water used for performing hydrolysis and condensation is normally 0.9 to 1.6 equivalents, preferably 1.0 to 1.3 equivalents, with respect to 1 equivalent of a total amount of the hydrolyzable groups (e.g. chloro groups) in the above silane compound having a hydrolyzable group(s). When such amount of water added is within the range of 0.9 to 1.6 equivalents, a composition described later tends to exhibit a superior workability, and a cured product thereof tends to exhibit a superior toughness.

It is preferred that the above silane compound having a hydrolyzable group(s) be hydrolyzed in an organic solvent such as alcohols, ketones, esters, cellosolves and aromatic compounds, before use. Specifically, preferred are, for example, alcohols such as methanol, ethanol, isopropyl alcohol, isobutyl alcohol, n-butanol and 2-butanol; and aromatic compounds such as toluene and xylene. Here, isopropyl alcohol, toluene or a combination of isopropyl alcohol and toluene is more preferable in terms of achieving a superior curability of the composition obtained and a superior toughness of the cured product thereof.

It is preferred that a reaction temperature for performing hydrolysis and condensation be 10 to 120°C, more preferably 20 to 80°C. When the reaction temperature is within such ranges, gelation is less likely to take place such that there can be obtained a solid hydrolysis condensate capable of being used in a next operation.

It is preferred that the organopolysiloxane as the component (A) be contained in the heat-curable silicone resin composition of the present invention, by an amount of 5 to 30% by mass, more preferably 7 to 28% by mass, or even more preferably 8 to 25% by mass.

### (B) Organopolysiloxane

An organopolysiloxane as a component (B) has a linear diorganopolysiloxane(s) residue represented by the following general formula (2), and has in one molecule at least one, preferably not less than two cyclohexyl groups or phenyl groups.

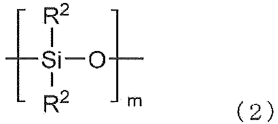

In the above formula (2), each R² independently represents a group selected from a hydroxyl group, an alkyl group having 1 to 3 carbon atoms, a cyclohexyl group, a phenyl group, a vinyl group and an allyl group. R² preferably represents a methyl group or a phenyl group. m represents an integer of 5 to 50, preferably 8 to 40, more preferably 10 to 35. When m is smaller than 5, the cured product obtained tends to exhibit a poor crack resistance, and a device having such cured product may thus exhibit a warpage. Further, when m is greater than 50, the cured product obtained tends to exhibit an insufficient mechanical strength.

In addition to the D unit (R²₂ SiO_{2/2}) represented by the above formula (2), the component (B) may also contain D unit (R₂ SiO_{2/2}) which is not represented by the above formula (2), an M unit (R₃SiO_{1/2}) and/or a T unit (RSiO_{3/2}). It is preferred that a ratio of D unit: M unit: T unit be 90 to 24: 75 to 9 : 50 to 1, particularly preferably 70 to 28 : 70 to 20 : 10 to 2 (provided that a sum total of these units is 100) in terms of the properties of the cured product. Here, R represents a hydroxyl group, a methyl group, an ethyl group, a propyl group, a cyclohexyl group, a phenyl group, a vinyl group or an allyl group. In addition to the above units, the component (B) may also contain a Q unit (SiO_{4/2}). It is preferred that the organopolysiloxane as the component (B) have in one molecule at least one cyclohexyl group or phenyl group, among the D unit (R²₂ SiO) represented by the above formula (2), D unit (R₂ SiO) which is not represented by the above formula (2), the M unit (R₃SiO_{1/2}) and/or a T unit (RSiO_{3/2}).

It is preferred that not less than 30% (e.g. 30 to 90%), particularly preferably not less than 50% (e.g. 50 to 80%) of the organopolysiloxane as the component (B) be repeating D units (R²₂SiO_{2/2}) represented by the general formula (2) in a molecule. Further, it is preferred that the weight-average molecular weight of the component (B) be 3,000 to 100,000, more preferably 10,000 to 100,000, in terms of polystyrene when measured through gel permeation chromatography (GPC). It is preferable when such molecular weight is within these ranges, because the component (B) will be in a solid or semisolid state within such ranges, and the composition obtained will thus exhibit a favorable workability and curability.

Here, examples of a raw material of the T unit (RSiO_{3/2}) include trichlorosilanes such as methyltrichlorosilane, ethyltrichlorosilane, propyltrichlorosilane, phenyltrichlorosilane and cyclohexyltrichlorosilane; and alkoxysilanes such as trimethoxysilanes corresponding to each of these trichlorosilanes.

Below are examples of a raw material of the D unit (R²₂ SiO_{2/2}) as the linear diorganopolysiloxane residue represented by the above formula (2).

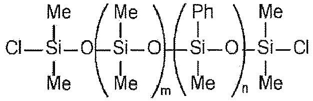

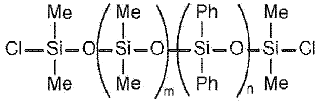

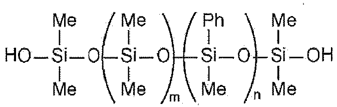

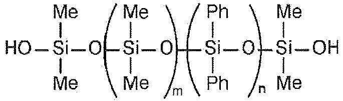

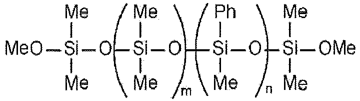

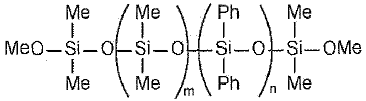

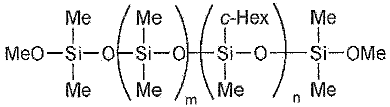

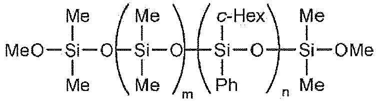

(Here, m is an integer of 3 to 48 (mean value), n is an integer of 0 to 48 (mean value), and m + n is 3 to 48 (mean value); Me represents a methyl group; Ph represents a phenyl group; and c-Hex represents a cyclohexyl group.)

Further, examples of raw materials of the M unit and the D unit which is not represented by the above formula (2) include mono- or dichlorosilanes such as Me₂PhSiCl, Me₂ViSiCl, Ph₂MeSiCl, Ph₂ViSiCl, Me₂SiCl₂, MeEtSiCl₂, ViMeSiCl₂, Ph₂SiCl₂ and PhMeSiCl₂; and mono- or dialkoxysilanes such as mono- or dimethoxysilanes corresponding to each of these chlorosilanes. Here, Me represents a methyl group, Et represents an ethyl group, Ph represents a phenyl group, and Vi represents a vinyl group.

The component (B) can be obtained by combining each compound which is a raw material for each unit described above in a way such that a produced polymer has a given molar ratio for each unit, and then by reacting the same in, for example, the following manner. That is, a mixed silane prepared by mixing phenylmethyldichlorosilane, phenyltrichlorosilane, a both-chloro-terminated dimethylsilicone oil having 21 Si atoms, and toluene, is delivered by drops into water so as to perform cohydrolysis at 30 to 50°C for an hour. Next, the hydrolyzed mixed silane is matured at 50°C for an hour, followed by pouring water thereinto so as to wash the matured product, and then performing azeotropic dehydration; and/or polymerization at 25 to 40°C using ammonia or the like as a catalyst, before carrying out filtration; and then stripping under a reduced pressure.

The component (B) prepared through cohydrolysis and condensation in the above manner may contain siloxane units having silanol groups. The organopolysiloxane as the component (B) normally contains such silanol group-containing siloxane unit by an amount of 0.5 to 10%, preferably about 1 to 5%, with respect to all siloxane units. Examples of such silanol group-containing siloxane unit include an R (OH) SiO_{2/2} unit, an R (OH)₂ SiO_{1/2} unit and an R² (OH) SiO_{1/2} unit (R represents any of the abovementioned groups other than a hydroxyl group). Since such organopolysiloxane contains silanol groups, it is capable of undergoing a condensation reaction with the resinous polyorganosiloxane as the component (A) which is represented by the above formula (1) and contains hydroxyl groups.

It is preferred that the component (B) be added in an amount of 5 to 30 parts by mass, more preferably 10 to 20 parts by mass, with respect to a total of 100 parts by mass of the components (A) and (B). When the component (B) is added in an amount of smaller than 5 parts by mass, there will only be achieved a small effect in improving a continuous moldability of the composition obtained, and the cured product obtained tends to exhibit an impaired low-warpage property and crack resistance in such case. Further, when the component (B) is in an amount of greater than 30 parts by mass, the composition obtained tends to exhibit an increased viscosity, which may then impair molding.

The components (A) and (B) are melted and mixed together in advance so as to produce a mixture thereof, followed by melting and mixing such mixture with an other component(s). If the components (A) and (B) are not melted and mixed together in advance, the dispersibilities of the components (A) and (B) will not be improved, which makes it impossible for the components (A) and (B) to form a sea-island structure. Therefore, a stress relaxation effect of the component (B) will be impaired in such case. Moreover, if the components (A) and (B) are not melted and mixed together in advance, the handling property of the resin will be impaired, and the moldability will be significantly impaired due to gelation, in the next step where an other component(s) and the mixture of the components (A) and (B) are melted and mixed together.

By melting and mixing the components (A) and (B) in advance, the moldability of the composition of the invention improves, and the cured product obtained from the composition of the invention exhibits within 4,000 MPa difference between storage elastic modulus at 25°C and that at 150°C.

### (C) Inorganic filler

An inorganic filler as a component (C) is added to improve the strength of the cured product of the silicone resin composition of the present invention. As such inorganic filler (C), there can be used those that are normally added to silicone resin compositions and epoxy resin compositions. Examples of such inorganic filler include silicas such as spherical silica, a molten silica and a crystalline silica; alumina; silicon nitride; aluminum nitride; boron nitride; glass fibers; glass particles; and antimony trioxide. However, a later-described white pigment (white coloring agent) as a component (F) is excluded from the examples of such inorganic filler.

There are no particular restrictions on the average particle diameter and shape of the inorganic filler as the component (C). A spherical silica having an average particle diameter of 0.5 to 30 µm is preferred. When the average particle diameter of the spherical silica as the component (C) is greater than 30 µm, an invasiveness of the composition toward a narrow gap will be significantly impaired. Further, it is not preferable when a crushed silica is contained in the composition, because while the strength of the cured product obtained will be improved in such case, the fluidity of the composition will be significantly impaired. Here, the aforementioned average particle diameter refers to a value obtained as a mass mean value Dso (or median diameter) as a result of performing particle size distribution measurement through a laser diffraction method.

Moreover, in terms of achieving a high fluidity of the composition obtained, it is preferred that there be used in combination a spherical silica of a microscopic range of 0.1 to 3 µm, a spherical silica of a middle particle size range of 3 to 7 µm and a spherical silica of a coarse range of 10 to 30 µm.

The inorganic filler as the component (C) is added in an amount of 330 to 850 parts by mass, particularly preferably 350 to 800 parts by mass, with respect to the total of 100 parts by mass of the components (A) and (B). When the component (C) is in an amount of smaller than 330 parts by mass, a cured product with a sufficient strength may not be able to be obtained. When the component (C) is in an amount of greater than 850 parts by mass, an increased viscosity of the composition obtained may lead to a filling failure and an impaired flexibility of the cured product, which may then lead to failures such as peeling inside an element. Here, it is preferred that the component (C) be contained in the whole silicone resin composition of the present invention at a ratio of 20 to 90% by mass, particularly preferably 40 to 88% by mass.

### (D) Curing catalyst

A curing catalyst as a component (D) is a condensation catalyst used to cure the heat-curable organopolysiloxanes as the components (A) and (B), and is selected in view of, for example, stabilities, coating-film hardnesses, non-yellowing properties and curabilities of the components (A) and (B). Preferable examples of an organic metal catalyst include an organic acid zinc, an organic aluminum compound and an organic titanium compound. Specific examples of such organic metal catalyst include zinc benzoate, zinc octylate, p-tert-butyl zinc benzoate, zinc laurate, zinc stearate, aluminum triisopropoxide, aluminum acetylacetonate, ethyl acetoacetate aluminum di(n-butylate), aluminum-n-butoxy diethylaceto acetate ester, tetrabutyl titanate, tetraisopropyl titanate, tin octylate, cobalt naphthenate and tin naphthenate. Among these organic metal catalysts, zinc benzoate is preferred.

The curing catalyst is added in an amount of 0.01 to 10 parts by mass, particularly preferably 0.1 to 1.6 parts by mass, with respect to the total of 100 parts by mass of the organopolysiloxanes as the components (A) and (B). When the added amount of the curing catalyst is within these ranges, the silicone resin composition obtained will exhibit a favorable curability and become stable.

### (E) Silane coupling agent

A silane coupling agent as a component (E) is added to the silicone resin composition of the present invention to improve, for example, a bond strength between the silicone resin and the inorganic filler, an adhesion to a metal and the fluidity of the silicone resin composition. As such silane coupling agent and in terms of improving the bond strength and adhesion, preferred is a type of silane coupling agent having at least one functional group selected from, for example, an epoxy group, an amino group and a mercapto group.

Specific examples of such coupling agent include an epoxy functional alkoxysilane such as γ-glycidoxypropyltrimethoxysilane, γ-glycidoxypropylmethyldiethoxysilane and β-(3,4-epoxycyclohexyl) ethyltrimethoxysilane; an amino functional alkoxysilane such as N-β (aminoethyl)-γ-aminopropyltrimethoxysilane, γ-aminopropyltriethoxysilane and N-phenyl-γ-aminopropyltrimethoxysilane; and a mercapto functional alkoxysilane such as γ-mercaptopropyltrimethoxysilane.

Further, in order to improve the fluidity, it is preferred that there be used a type of silane coupling agent having an alkyl group(s) such as a methyl group and an n-hexyl group.

The component (E) is added in an amount of 0.1 to 8.0 parts by mass, particularly preferably 0.5 to 6.0 parts by mass, with respect to the total of 100 parts by mass of the components (A) and (B). When the component (E) is in an amount of smaller than 0.1 parts by mass, there will be exhibited an insufficient bond strength between the resin and the filler, an insufficient adhesion effect to a base material, and an insufficient effect in improving the fluidity. Further, when the component (E) is in an amount of greater than 8.0 parts by mass, the viscosity of the composition may decrease to an extremely low level, which may then become the cause for void formation.

In the present invention, other than the above essential components, there may also be added the following optional components if needed.

### (F) White pigment

There can be further added a white pigment as a component (F) to improve a whiteness of the heat-curable silicone resin composition of the invention, if the composition is to be used in an optical semiconductor device. As such white pigment as the component (F), there may be employed those that are normally used in a silicone resin composition and an epoxy resin composition whose cured products are used as, for example, reflectors for use in optical semiconductor devices. Examples of such white pigment include titanium dioxide, zinc oxide, rare-earth oxides, zinc sulfate and magnesium oxide. Each one of these white pigments may be used singularly, or the white pigment as the component (F) may be a mixture of serval of these white pigments.

Among the above white pigments, it is preferred that titanium dioxide be used as the white pigment as the component (F) for the purpose of improving the whiteness. The unit lattice of such titanium dioxide can be categorized as rutile type, anatase type and brookite type, and a titanium dioxide of any of these types may be used. Particularly, a rutile-type titanium dioxide is preferred in terms of stability and photocatalytic capacity of titanium dioxide. Further, although such titanium dioxide may be produced through, for example, a sulfuric acid method or a chlorine method, it is preferred that it be produced through a chlorine method in terms of whiteness.

Moreover, while there are no restrictions on the average particle diameter and shape of the component (F), it is preferred that the average particle diameter thereof be 0.05 to 5.0 µm, more preferably 0.05 to 1.0 µm, particularly preferably 0.05 to 0.50 µm. Here, the aforementioned average particle diameter refers to a value obtained as a mass mean value D₅₀ (or median diameter) as a result of performing particle size distribution measurement through a laser diffraction method. In order to improve a compatibility or dispersibility to the resin component and/or inorganic filler, the component (F) may be surface-treated in advance with, for example: a hydrous oxide of, for example, aluminum or silicon; an organic substance such as polyol; or organic polysiloxane.

The component (F) is normally added in an amount of 3 to 300 parts by mass, preferably 5 to 200 parts by mass, with respect to the total of 100 parts by mass of the components (A) and (B). When the component (F) is in an amount of smaller than 3 parts by mass, there may not be achieved a sufficient whiteness. Further, when the component (F) is in an amount of greater than 300 parts by mass, not only there will be smaller portions of other components added to improve the mechanical strength, but the moldability of the composition obtained may be significantly impaired. Here, it is preferred that the component (F) be contained in the entire silicone resin composition of the invention at a ratio of 1 to 50% by mass, more preferably 3 to 40% by mass.

### (G) Mold release agent

A mold release agent as a component (G) may be added to the heat-curable silicone resin composition of the present invention to improve mold releasability from a mold at the time of pressure molding (i.e. tableting) under a room temperature. It is preferred that the component (G) be added and contained in an amount of 0.2 to 5.0% by mass with respect to the whole composition. The mold release agent may be, for example, a natural wax or a synthetic wax. Examples of such synthetic wax include a hydrocarbon-based wax, a fatty acid amide-based wax, a hydrogen hardened oil, an acid wax, a polyethylene wax and a fatty acid wax. Here, preferred is a fatty acid wax; and particularly preferred are calcium stearate and stearic acid ester each having a melting point of 120 to 140°C.

### Other additives

Various additives may be further added to the heat-curable silicone resin composition of the present invention if necessary. For example, in order to improve the properties of the resin, there may be employed additives such as an other type(s) of organopolysiloxane(s); a silicone powder; a silicone oil; a thermoplastic resin; a thermoplastic elastomer; or an organic synthetic rubber, without impairing the effects of the present invention. Further, there may also be added a carbon black as a black pigment for use in semiconductor packaging.

### Production method of composition

The composition of the present invention is produced as follows. That is, the components (A) and (B) are melted and mixed in advance through, for example, a heated roll, a kneader, an extruding machine or an extruder, followed by cooling and then crushing the same so as to obtain a mixture of the components (A) and (B). Later, such mixture is combined with the inorganic filler as the component (C), the curing catalyst as the component (D) and the silane coupling agent as the component (E) at the given composition ratios, followed by melting and mixing the same through, for example, a heated roll, a kneader, an extruding machine or an extruder, and then performing cooling so as to solidify the mixture before crushing it into pieces of an appropriate size. In this way, there can be obtained the heat-curable silicone resin composition as a molding material.

It is desired that such heat-curable silicone resin composition be molded through compression molding. Compression molding in such case is performed at a molding temperature of 120 to 180°C for a molding time of 30 to 900 sec. It is particularly preferred that such compression molding be performed at a molding temperature of 130 to 150°C for a molding time of 60 to 600 sec. Further, it is preferred that post curing be performed at 150 to 200°C for 2 to 20 hours. Furthermore, this heat-curable silicone resin composition may also be molded through, for example, transfer molding or injection molding, when performing molding evaluation.

### Working example

The present invention is described in detail hereunder with reference to working and comparative examples. However, the present invention is not limited to the following working examples.

All components used in working and comparative examples are listed below. Here, a weight-average molecular weight refers to a value measured under the following conditions.
Measurement condition
Developing solvent: Tetrahydrofuran
Flow rate: 0.35 mL/min
Detector: RI
Column: TSK-GEL type H (by Tosoh Corporation)
Column temperature: 40°C
Injected amount of sample: 5 µL

### Synthesis of (A) resinous organopolysiloxane

### Synthetic example 1

A methyltrichlorosilane of 100 parts by mass and a toluene of 200 parts by mass were put into a 1L flask, followed by delivering thereinto by drops a mixed solution of water of 8 parts by mass and an isopropyl alcohol of 60 parts by mass under an ice-cooled condition. Five hours were spent in delivering such mixed solution by drops while maintaining an inner temperature at -5 to 0°C, followed by heating and stirring the same at a reflux temperature of 110 to 130°C for 20 min. Next, the solution was cooled down to a room temperature, followed by spending 30 min in delivering by drops water of 12 parts by mass at a temperature of not higher than 30°C, and then by stirring the solution for another 20 min. Water of 25 parts by mass was further delivered thereinto by drops, followed by stirring the solution at 40 to 45°C for 60 min. Later, water of 200 parts by mass was put thereinto so as to separate an organic layer. This organic layer was then washed until it had neutralized, followed by performing azeotropic dehydration; filtration; and stripping under a reduced pressure so as to obtain 36.0 parts by mass of a heat-curable organopolysiloxane (A-1) which is represented by the following average formula (A-1), as a colorless and transparent solid (melting point: 76°C, weight-average molecular weight: 3,060).

(CH₃)_{1.0}Si(OC₃H₇)_{0.07}(OH)_{0.10}O_{1.4} (A-1)

### Synthesis of (B) organopolysiloxane

### Synthetic example 2

Delivered into water of 11,000 g by drops was a mixed silane prepared by mixing 100 g (4.4 mol%) of a phenylmethyldichlorosilane; 2,100 g (83.2 mol%) of a phenyltrichlorosilane; 2,400 g (12.4 mol%) of a dimethylpolysiloxane oil having 21 Si atoms and with both of its terminal ends being blocked by a chloro group; and 3,000 g of toluene, followed by performing cohydrolysis at 30 to 50°C for an hour. Next, the cohydrolyzed mixed silane was matured at 30°C for an hour, followed by pouring water therein so as to wash the same. The mixed silane thus washed was then subjected to azeotropic dehydration; filtration; and stripping under a reduced pressure, thus obtaining a colorless and transparent product (organosiloxane (B-1)). This siloxane (B-1) exhibited a melt viscosity of 5 Pa·s when measured by an ICI cone-plate at 150°C, a weight-average molecular weight of 50,000, and a ratio of a silanol unit to the total number of all siloxane units of 3.3%.

[(Me₂SiO)₂₁]_{0.124}(PhMeSiO)_{0.044}(PhSiO_{1.5})_{0.832} (B-1)

### (C) Inorganic filler

(C-1) Molten spherical silica (CS-6103 53C2 by Tatsumori Ltd.; average particle diameter 10 µm)

### (D) Curing catalyst

(D-1) Zinc benzoate (by Wako Pure Chemical Industries, Ltd.)

### (E) Silane coupling agent

(E-1) 3-mercaptopropyltrimethoxysilane (KBM-803 by Shin-Etsu Chemical Co., Ltd.)

### (F) White pigment

(F-1) Rutile-type titanium dioxide (PC-3 by ISHIHARA SANGYO KAISHA, LTD.)

### (G) Mold release agent

(G-1) Ester-based mold release agent (KAOWAX 220 by Kao Corporation)

### Working examples 1 to 4; Comparative examples 1 to 6

In working examples 1 to 4, the components (A) and (B) of the amounts (parts by mass) shown in Table 1 were melted and mixed by a kneader in advance, followed by cooling and then crushing the same so as to obtain a mixture. Next, the mixture of the components (A) and (B); and the rest of the components of the amounts (parts by mass) shown in Table 1, were mixed by a single screw extruder, followed by cooling and then crushing a mixture thus obtained so as to obtain a heat-curable silicone resin composition.

In comparative examples 1 to 4 , the components (A) and (B) were not melted and mixed by a kneader. Instead, the amounts (parts by mass) of the components shown in Table 1 were treated by a single screw extruder, followed by performing cooling and then crushing so as to obtain a heat-curable silicone resin composition. The following properties of these compositions were then measured. The measurement results are shown in Table 1.

In comparative examples 5 to 6, the components (A) and (B) of the amounts (parts by mass) shown in Table 1 were melted and mixed by a kneader in advance, followed by cooling and then crushing the same so as to obtain a mixture. Next, the mixture of the components (A) and (B); and the rest of the components of the amounts (parts by mass) shown in Table 1, were mixed by a single screw extruder, followed by cooling and then crushing a mixture thus obtained so as to obtain a heat-curable silicone resin composition.

### Comparative examples 7 and 8

As shown in Table 1, heat-curable silicone resin compositions were prepared in a similar manner as working example 1, except that an epoxy resin (TEPIC-s by Nissan Chemical Industries, Ltd.) and an acid anhydride (RIKACID MH by New Japan Chemical Co., Ltd.) were used instead of the components (A) and (B); and a phosphorous curing accelerator (U-CAT 5003 by San-Apro Ltd.) was used instead of the component (D). The following properties of these compositions were measured, and the results thereof are shown in Table 1.

### Storage elastic modulus

A mold manufactured in accordance with JIS K6911:2006 was used to mold the above heat-curable silicone resin composition at a molding temperature of 150°C and under a molding pressure of 6.9 N/mm² for a molding time of 300 sec, followed by performing post curing at 150°C for 4 hours. A sample of the post-cured molded product was then subjected to a storage elastic modulus measurement, using a kinetic viscoelasticity measurement device DMS 120 (by Seiko Instruments Inc.). Specifically, the storage elastic modulus measurement was conducted at a temperature rising rate of 10°C/min and within a temperature range of 0 to 200°C. More specifically, measured were the storage elastic moduluses of the sample at 25°C and 150°C.

### Light resistance test

A disk-shaped cured product having a diameter of 50 mm and a thickness of 3 mm was prepared by performing molding at a molding temperature of 150°C and under a molding pressure of 6.9 N/mm² for a molding time of 300 sec. The disk-shaped cured product was then subjected to UV irradiation (60 mW/cm: high-pressure mercury lamp with a peak wavelength of 365 nm) for 300 hours, followed by observing the appearance thereof.

### Filling property and warpage judgment

A wafer molding device MZ407-1 (by APIC YAMADA CORPORATION) was used to mold the above heat-curable silicone resin composition on an 20.32 cm (8 inch) wafer having a thickness of 725 µm, in a way such that a resin thickness was also set to 725 µm on the wafer, and molding was performed at 150°C for 300 sec. A filling property of the resin composition was then examined. Further, there was also examined a warpage of such wafer after performing post curing at 150°C for 4 hours. Examples where the wafer had exhibited a warpage of not larger than 1 mm were marked "o"; examples where the wafer had exhibited a warpage of not larger than 1.5 mm were marked "△"; and examples where the wafer had exhibited a warpage of larger than 1.5 mm were marked "×".

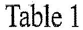

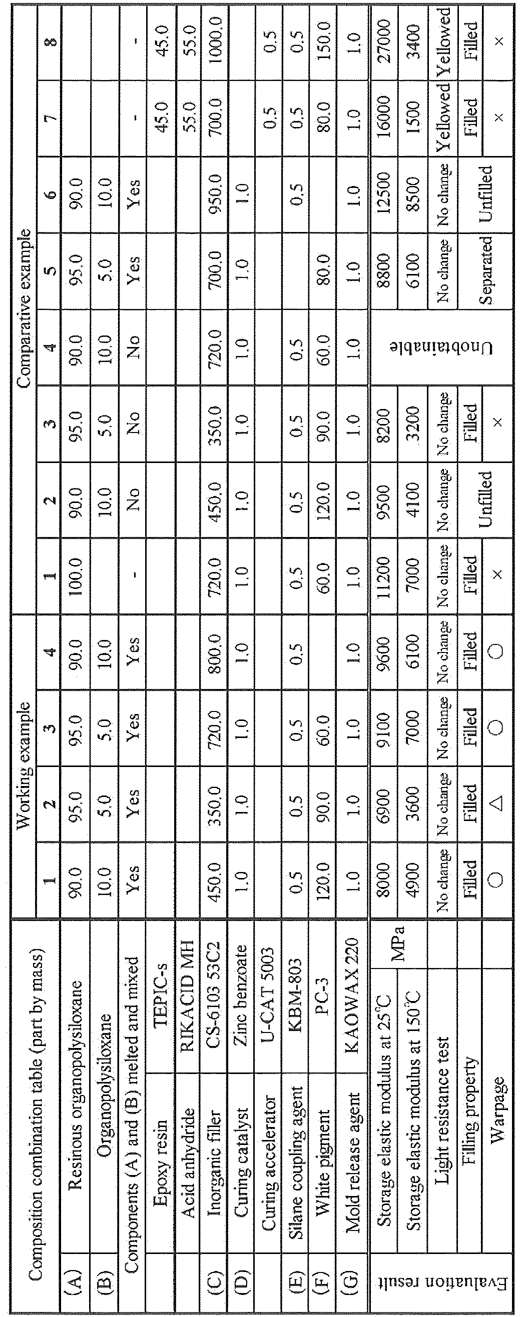

As shown in Table 1, in each of working examples 1 to 4 where the components (A) and (B) were melted and mixed in advance, the difference between the storage elastic modulus at 25°C and the storage elastic modulus at 150°C was not larger than 4,000 MPa. That is, it was confirmed that the cured product of the heat-curable silicone resin composition of the present invention had a favorable reliability while exhibiting a low-warpage property.

## Claims

1. A heat-curable silicone resin composition comprising:
a molten mixture of
(A) a resinous organopolysiloxane that has a weight-average molecular weight of 500 to 20,000 in terms of polystyrene, and is represented by the following average composition formula (1)
(CH₃)ₐSi(OR¹)_{b}(OH)_{c}O_{(4-a-b-c)/2} (1)
wherein each R¹ represents an identical or different organic group having 1 to 4 carbon atoms, and a, b and c are numbers satisfying 0.8 ≤ a ≤ 1.5, 0 ≤ b ≤ 0.3, 0.001 ≤ c ≤ 0.5 and 0. 801 ≤ a+b+c < 2, and
(B) an organopolysiloxane that contains in one molecule at least one cyclohexyl group or phenyl group, and has a linear diorganopolysiloxane residue represented by the following general formula (2) 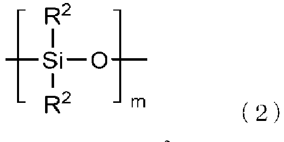 wherein each R² independently represents a monovalent hydrocarbon group selected from a hydroxyl group, an alkyl group having 1 to 3 carbon atoms, a cyclohexyl group, a phenyl group, a vinyl group and an allyl group, and m represents an integer of 5 to 50;
(C) an inorganic filler added in an amount of 330 to 850 parts by mass, with respect to the total of 100 parts by mass of the components (A) and (B);
(D) a curing catalyst added in an amount of 0.01 to 10 parts by mass, with respect to the total of 100 parts by mass of the organopolysiloxanes as the components (A) and (B); and
(E) a silane coupling agent added in an amount of 0.1 to 8.0 parts by mass, with respect to the total of 100 parts by mass of the components (A) and (B), wherein the components (A) and (B) are to be cured by a condensation reaction, and a difference between a storage elastic modulus of a cured product of the composition at 25°C and a storage elastic modulus of the cured product of the composition at 150°C is not larger than 4,000 MPa, wherein the cured product is prepared by performing molding at a molding temperature of 150°C and under a molding pressure of 6.9 N/mm² for a molding time of 300 sec using a mold manufactured in accordance with JIS K6911:2006, and then performing post curing at 150°C for 4 hours, while the storage elastic modulus is measured at a temperature rising rate of 10°C/min and within a temperature range of 0 to 200°C.

2. The heat-curable silicone resin composition according to claim 1, further comprising a white pigment as a component (F).

3. The heat-curable silicone resin composition according to claim 2, wherein the white pigment as the component (F) is at least one selected from the group consisting of titanium dioxide, zinc oxide, rare-earth oxide, zinc sulfate and magnesium oxide.

4. The heat-curable silicone resin composition according to any one of claims 1 to 3, wherein the curing catalyst as the component (D) is an organic metal condensation catalyst.

5. The heat-curable silicone resin composition according to any one of claims 1 to 4, wherein in the resinous organopolysiloxane as the component (A), a ratio of a number of T units (CH₃SiO_{3/2}) to a total number of all siloxane units is not smaller than 70%.

6. An optical semiconductor device produced using the heat-curable silicone resin composition as set forth in any one of claims 1 to 5.

7. A semiconductor package produced using the heat-curable silicone resin composition as set forth in any one of claims 1 to 5.

## Patentansprüche

1. Wärmehärtbare Silikonharzzusammensetzung, umfassend:
eine geschmolzene Mischung aus
(A) einem harzartigen Organopolysiloxan, das ein gewichtsmittleres Molekulargewicht von 500 bis 20.000, bezogen auf Polystyrol, aufweist und durch die folgende durchschnittliche Zusammensetzungsformel (1) dargestellt wird
(CH₃)ₐSi(OR¹)_{b}(OH)_{c}O_{(4-a-b-c)/2} ₍₁)
worin jedes R¹ eine gleiche oder verschiedene organische Gruppe mit 1 bis 4 Kohlenstoffatomen darstellt und a, b und c Zahlen sind, die 0,8 ≤ a ≤ 1,5, 0 ≤ b ≤ 0,3, 0,001 ≤ c ≤ 0,5 und 0,801 ≤ a+b+c < 2 erfüllen, und
(B) ein Organopolysiloxan, das in einem Molekül mindestens eine Cyclohexylgruppe oder Phenylgruppe enthält und einen linearen Diorganopolysiloxanrest der folgenden allgemeinen Formel (2) aufweist 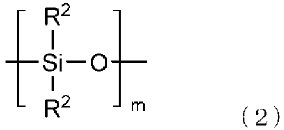 worin jedes R² unabhängig voneinander eine einwertige Kohlenwasserstoffgruppe darstellt, ausgewählt aus einer Hydroxylgruppe, einer Alkylgruppe mit 1 bis 3 Kohlenstoffatomen, einer Cyclohexylgruppe, einer Phenylgruppe, einer Vinylgruppe und einer Allylgruppe, und m eine ganze Zahl von 5 bis 50 darstellt;
(C) einen anorganischen Füllstoff in einer Menge von 330 bis 850 Masseteilen, bezogen auf die Gesamtmenge von 100 Masseteilen der Komponenten (A) und (B);
(D) einen Härtungskatalysator, der in einer Menge von 0,01 bis 10 Masseteilen, bezogen auf die Gesamtmenge von 100 Masseteilen der Organopolysiloxane als Komponenten (A) und (B), zugesetzt wird; und
(E) einen Silan-Haftvermittler, der in einer Menge von 0,1 bis 8,0 Masseteilen, bezogen auf die Gesamtmenge von 100 Masseteilen der Komponenten (A) und (B), zugesetzt wird, wobei die Komponenten (A) und (B) durch eine Kondensationsreaktion zu härten sind, und eine Differenz zwischen einem Speicherelastizitätsmodul eines gehärteten Produkts der Zusammensetzung bei 25°C und einem Speicherelastizitätsmodul des gehärteten Produkts der Zusammensetzung bei 150°C nicht größer als 4000 MPa ist, wobei das gehärtete Produkt durch Formen bei einer Formtemperatur von 150°C und unter einem Formdruck von 6,9 N/mm2 für eine Formzeit von 300 Sekunden unter Verwendung einer gemäß JIS K6911:2006 hergestellten Form hergestellt wird und dann ein Nachhärten bei 150°C für 4 Stunden durchgeführt wird, während der Speicherelastizitätsmodul bei einer Temperaturanstiegsrate von 10°C/min und innerhalb eines Temperaturbereichs von 0 bis 200°C gemessen wird.

2. Wärmehärtbare Siliconharzzusammensetzung nach Anspruch 1, die ferner ein Weißpigment als Komponente (F) enthält.

3. Wärmehärtbare Siliconharzzusammensetzung nach Anspruch 2, wobei das Weißpigment als Komponente (F) mindestens eines ist, das aus der Gruppe ausgewählt ist, die aus Titandioxid, Zinkoxid, Seltenerdoxid, Zinksulfat und Magnesiumoxid besteht.

4. Wärmehärtbare Silikonharzzusammensetzung nach einem der Ansprüche 1 bis 3, wobei der Härtungskatalysator als Komponente (D) ein organischer Metallkondensationskatalysator ist.

5. Wärmehärtbare Siliconharzzusammensetzung nach einem der Ansprüche 1 bis 4, wobei in dem harzartigen Organopolysiloxan als Komponente (A) das Verhältnis der Anzahl der T-Einheiten (CH ₃SiO _{3/2}) zur Gesamtzahl aller Siloxaneinheiten nicht kleiner als 70% ist.

6. Optische Halbleitervorrichtung, hergestellt unter Verwendung der wärmehärtbaren Silikonharzzusammensetzung nach einem der Ansprüche 1 bis 5.

7. Halbleitergehäuse, hergestellt unter Verwendung der wärmehärtbaren Siliconharzzusammensetzung nach einem der Ansprüche 1 bis 5.

## Revendications

1. Composition de résine de silicone thermodurcissable comprenant :
un mélange fondu de
(A) un organopolysiloxane résineux qui possède un poids moléculaire moyen en poids de 500 à 20 000 en termes de polystyrène, et est représenté par la formule de composition moyenne (1) suivante
(CH₃)aSi(OR¹)_{b}(OH)_{c}O_{(4-a-b-c)/2} (1)
dans laquelle chaque R¹ représente un groupe organique identique ou différent ayant 1 à 4 atomes de carbone, et a, b et c sont des nombres satisfaisant 0,8 ≤ a ≤ 1,5, 0 ≤ b ≤ 0,3, 0,001 ≤ c ≤ 0,5 et 0,801 ≤ a+b+c ≤ 2, et
(B) un organopolysiloxane qui contient dans une molécule au moins un groupe cyclohexyle ou un groupe phényle, et possède un résidu diorganopolysiloxane linéaire représenté par la formule générale (2) suivante 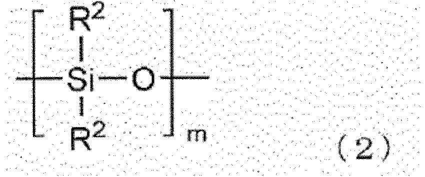 dans laquelle chaque R² représente indépendamment un groupe hydrocarboné monovalent choisi parmi un groupe hydroxyle, un groupe alkyle ayant 1 à 3 atomes de carbone, un groupe cyclohexyle, un groupe phényle, un groupe vinyle et un groupe allyle, et m représente un nombre entier de 5 à 50 ;
(C) une charge inorganique ajoutée en une quantité de 330 à 850 parties en masse, par rapport au total de 100 parties en masse des composants (A) et (B) ;
(D) un catalyseur de durcissement ajouté en une quantité de 0,01 à 10 parties en masse, par rapport au total de 100 parties en masse des organopolysiloxanes en tant que composants (A) et (B) ; et
(E) un agent de couplage de silane ajouté en une quantité de 0,1 à 8,0 parties en masse, par rapport au total de 100 parties en masse des composants (A) et (B), dans lequel les composants (A) et (B) doivent être durcis par une réaction de condensation, une différence entre un module d'élasticité de stockage d'un produit durci de la composition à 25 °C et un module d'élasticité de stockage du produit durci de la composition à 150 °C n'est pas supérieure à 4 000 MPa, dans lequel le produit durci est préparé en réalisant un moulage à une température de moulage de 150 °C et sous une pression de moulage de 6,9 N/mm² pour un temps de moulage de 300 s en utilisant un moule fabriqué selon la norme JIS K6911:2006, et en réalisant ensuite un post-durcissement à 150 °C pendant 4 heures, tandis que le module d'élasticité de stockage est mesuré à une vitesse d'augmentation de température de 10 °C/min et dans une plage de température de 0 à 200 °C.

2. Composition de résine de silicone thermodurcissable selon la revendication 1, comprenant en outre un pigment blanc en tant que composant (F).

3. Composition de résine de silicone thermodurcissable selon la revendication 2, dans laquelle le pigment blanc en tant que composant (F) est au moins l'un choisi dans le groupe constitué par le dioxyde de titane, l'oxyde de zinc, l'oxyde de terre rare, le sulfate de zinc et de l'oxyde de magnésium.

4. Composition de résine de silicone thermodurcissable selon l'une quelconque des revendications 1 à 3, dans laquelle le catalyseur de durcissement en tant que composant (D) est un catalyseur de condensation organométallique.

5. Composition de résine de silicone thermodurcissable selon l'une quelconque des revendications 1 à 4, dans laquelle dans l'organopolysiloxane résineux en tant que composant (A), un rapport d'un nombre de motifs T (CH₃SiO_{3/2}) à un nombre total de tous les motifs siloxane n'est pas inférieur à 70 %.

6. Dispositif à semi-conducteur optique produit en utilisant la composition de résine de silicone thermodurcissable selon l'une quelconque des revendications 1 à 5.

7. Boîtier à semi-conducteur produit en utilisant la composition de résine de silicone thermodurcissable selon l'une quelconque des revendications 1 à 5.
